(19) Europäisches Patentamt

European Patent Office

Office européen des brevets

(11) Veröffentlichungsnummer: **0 262 367**
**A1**

## (12) EUROPÄISCHE PATENTANMELDUNG

(21) Anmeldenummer: **87111911.1**

(22) Anmeldetag: **17.08.87**

(51) Int. Cl.4: **G01R 1/067 , G01R 31/28**

(30) Priorität: **30.09.86 DE 3633279**

(43) Veröffentlichungstag der Anmeldung:
**06.04.88 Patentblatt 88/14**

(84) Benannte Vertragsstaaten:
**AT BE CH DE FR GB IT LI NL SE**

(71) Anmelder: **Siemens Aktiengesellschaft Berlin und München**
**Wittelsbacherplatz 2**
**D-8000 München 2(DE)**

(72) Erfinder: **Argyo, Wilhelm**
**Erlkamerstrasse 8**
**D-8150 Holzkirchen(DE)**
Erfinder: **Nikutta, Wolfgang**
**Werinherstrasse 101**
**D-8000 München 90(DE)**
Erfinder: **Otto, Johann**
**Pater-Hammerschmid-Strasse 4**
**D-8170 Bad Tölz(DE)**

(54) **Mechanische Sonde zur Messung zeitabhängiger elektrischer Signale.**

㊼ Die Zeitabhängigkeit interner Signale wird üblicherweise an einem Spitzenmeßplatz mit Hilfe einer auf den interessierenden Meßpunkt aufgesetzten mechanischen Sonde bestimmt. Einige der internen Meßpunkte sind hierbei so ausgelegt, daß das Zeitverhalten eines an der Gate-Elektrode des Meßtransistors anliegenden Signals bisher nur mit Hilfe einer zweiten auf das Meßpad aufgesetzten Sonde überprüft werden konnte. Da eine solche Anordnung im allgemeinen eine zu große kapazitive Last für den Transistor ("Open-Drain"-Transistor) darstellt, werden die Signalflanken stark abgeflacht. Erfindungsgemäß wird deshalb vorgeschlagen, ein aktives oder passives Netzwerk in eine aktive Sonde zu integrieren und im Bereich der Sondennadel oder des Sondenarmes anzuordnen.

FIG 3

orthogonalen Richtungen gewährleisten. Der Sondenhalter 18 kann wahlweise mit Sondenarmen 18a in isolierter oder abgeschirmter Ausführung bestückt werden. In isolierter Ausführung besitzt der Sondenarm 18a beispielsweise einen Teflonkragen, der sich bis zur Sondenklemmung erstreckt. Die elektrische Verbindung erfolgt in diesem System direkt an der Sondennadel. Der abgeschirmte Sondenarm weist einen am Gehäuse des Sondenhalters angebrachten BNC-Stecker auf, der über ein Koaxialkabel mit der Sondenklemmung verbunden ist. Neben diesen inaktiven Systemen sind auch Sondenarme mit integrierter Verstärkerelektronik (aktive Sonden) insbesondere zur Untersuchung hochempfindlicher MOS-Bausteine und schneller bipolarer Schaltungen erhältlich. Die am Sondenarm 18a befestigte und mittels des Sondenhalters 18 auf einem Meßpunkt positionierte Sonde 18b besteht üblicherweise aus Wolfram und ist zumeist als Nadel mit Spitzenradien im Bereich weniger Mikrometer ($R \approx 1$ bis $5\ \mu$m) ausgebildet. Besondere Vorteile bieten flexible Sondennadeln die sich auch bei höherem Anpressdruck zerstörungsfrei aufsetzen lassen.

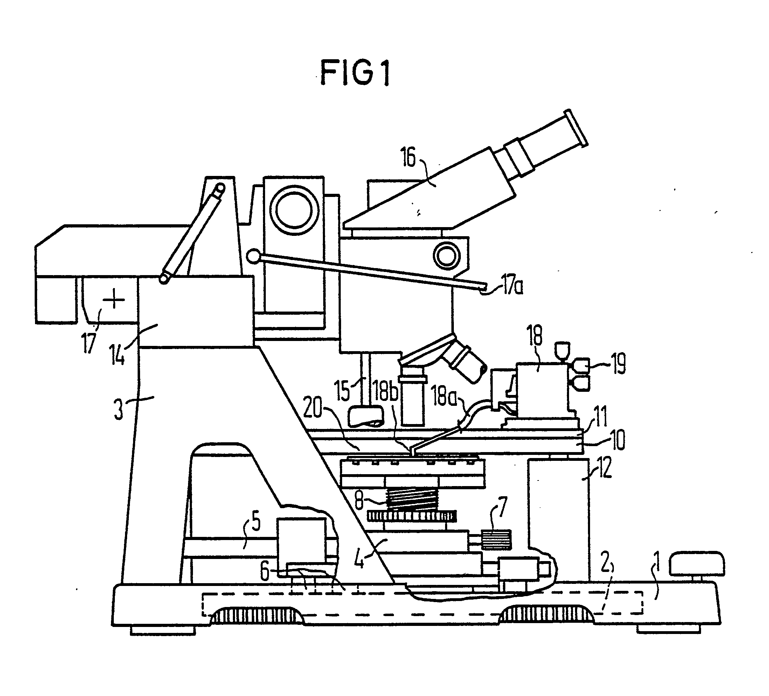

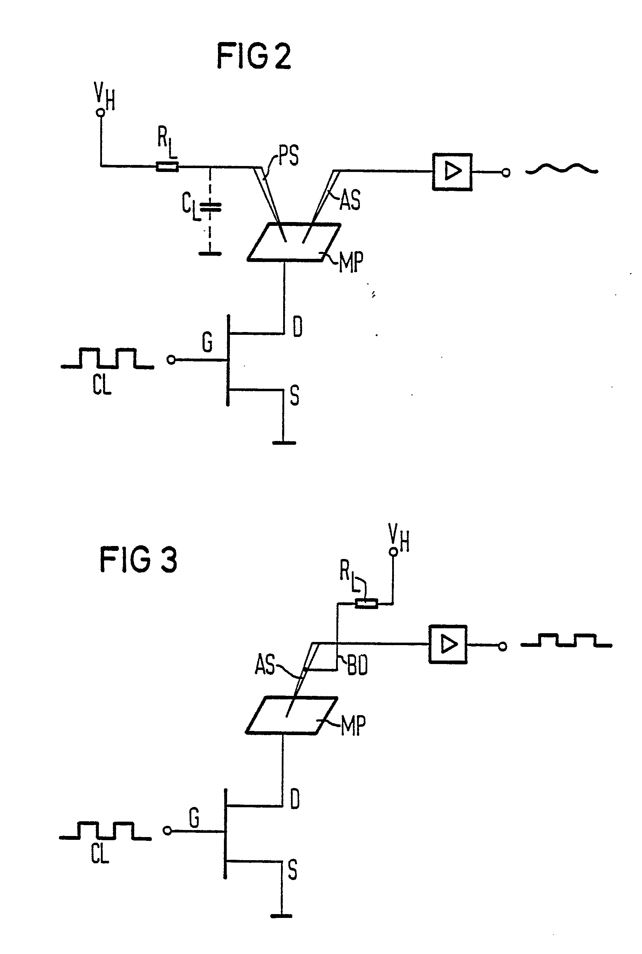

Eine konventionelle Anordnung zur Messung zeitabhängiger elektrischer Signale in Bauelementen der Mikroelektronik ist schematisch in Fig. 2 dargestellt. Diese Anordnung besteht aus zwei mechanischen Sonden AS bzw. PS die am Spitzenmeßplatz nach Fig. 1 unter mikroskopischer Kontrolle mit Hilfe zweier auf den Halbringen 11 fixierter Sondenhalter 18 auf einem internen Meßpunkt des auf dem Justiertisch 4 angeordneten Bauelementes 20 aufgesetzt werden. Der Meßpunkt ist in dem gezeigten Ausführungsbeispiel als MOS-Feldeffekttransistor ausgebildet, an dessen Gate-Elektrode G ein auf sein Zeitverhalten hin zu überprüfendes Signal CL angelegt wird und dessen Drain-Elektrode D mit dem der äußeren Kontaktierung dienenden Meßpad MP verbunden ist. Dieses Meßpad MP liegt üblicherweise in der obersten Metallisierungsebene des Bauelementes und besitzt eine Fläche von etwa 5 bis 10 $\mu$m². Um das Zeitverhalten des an der Gate-Elektrode G anliegenden Signals CL bestimmen zu können, mußte man bisher die Hilfsspannung $V_H$ über den äußeren Lastwiderstand $R_L$ und die erste Sonde PS an das Meßpad MP anlegen um den Transistor entsprechend der durch das Signal CL vorgegebenen Zeitabhängigkeit zu schalten. Die hieraus resultierenden zeitlichen Änderungen des Spannungsabfalls am Transistor konnten dann mit Hilfe der aktiven Sonde AS aufgenommen und verstärkt werden. Hierbei zeigte sich allerdings, daß zwei auf dem Meßpad MP aufgesetzte Sonden AS, PS im allgemeinen eine zu große kapazitive Last (in Fig. 2 - schematisch durch den Kondensator $C_L$ angedeutet) für den Transistor darstellen. Die Signalflanken wurden demzufolge stark abgeflacht und die Pulsbreiten waren nicht sicher nachweisbar. Die genaue Bestimmung der zeitlichen Lage der Signalflanken ist aber ebenso wie die Kenntnis der Pulsbreiten eine unabdingbare Voraussetzung für die interne Überprüfung der Funktionsweise mikroelektronischer Bauelemente.

Erfindungsgemäß wird deshalb vorgeschlagen, die Hilfsspannung $V_H$ über einen mit der aktiven Sonde AS leitend verbundenen Lastwiderstand $R_L$ an das Meßpad MP des Transistors heranzuführen (siehe Fig. 3). Um eine möglichst geringe Eigenkapazität dieser Meßanordnung zu gewährleisten, sollte der Lastwiderstand $R_L$ wie in Fig. 3 schematisch dargestellt im Bereich der Sondennadel oder des Sondenarmes angeordnet werden. Als Verbindungsteil zwischen Sondennadel und Lastwiderstand $R_L$ kommt vorzugsweise ein Bonddraht BD in betracht. Die erfindungsgemäße Anordnung kann bezüglich Eigenkapazität, Montier barkeit und Platzbedarf weiter verbessert werden, wenn man anstelle konventioneller Widerstände die in ihren Abmessungen sehr kleinen Chipwiderstände verwendet. Solche Chipwiderstände sind allgemein bekannt und beispielsweise von der Firma Rohrer GmbH, Buttermelcher-str. 16, 8000 München 5 erhältlich. Für die Dimensionierung des integrierten Lastwiderstandes $R_L$ sind die elektrischen Eigenschaften des dem Meßpad MP zugeordneten Transistors maßgebend. Ein maximaler Signalhub wird insbesondere dann erreicht, wenn der Lastwiderstand $R_L$ und der mittlere Widerstand des Transistors gleich groß sind.

Die erfindungsgemäße Sonde mit integriertem Lastwiderstand besitzt verglichen mit bekannten Anordnungen eine Reihe von Vorteilen. So ist es wegen der geringen Eigenkapazität der Sonde erstmals möglich, Signale mit Flankenanstiegszeiten von etwa $t \approx 1$ bis 2 ns und Pulsbreiten b < 10 ns aufzuzeichnen (Anordnung mit zwei aufgesetzten Meßspitzen: t 20 ns, b > 40 ns). Außerdem muß nur eine Sonde auf das Meßpad aufgesetzt werden, was das sichere Kontaktieren erheblich erleichtert. Es besteht dadurch auch die Möglichkeit, die Fläche des Meßpads und ggf. auch den dazugehörigen Transistor zu verkleinern. In einer erfindungsgemäßen Anordnung kann der bisher beschriebene Lastwiderstand $R_L$ selbstverständlich auch durch ein aktives oder passives Netzwerk ersetzt werden.

So ist es beispielsweise vorteilhaft, einen Transistor als variablen Widerstand zu verwenden. Mit einer solchen Anordnung ist es dann sehr leicht möglich, den äußeren Widerstandswert an die Kennlinie des dem Meßpad zugeordneten integrierten Meßtransistors anzupassen, d. h. $R_L$ statisch oder dynamisch für das jeweilige Meßproblem (steigende und/oder fallende Signalflanke) zu opti-

FIG 1

# FIG 2

$V_H$

$R_L$

PS

AS

$C_L$

MP

D

G

CL

S

# FIG 3

$V_H$

$R_L$

AS

BD

MP

D

G

CL

S

Europäisches
Patentamt

**EUROPÄISCHER RECHERCHENBERICHT**

Nummer der Anmeldung

EP 87 11 1911

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | HEWLETT-PACKARD JOURNAL, Band 28, Nr. 8, April 1977, Seiten 9-12; C.M. FINCH et al.: "Miniature oscilloscope probes for measurements in crowded circuits" * Seite 9, Absatz 2; Seite 11, rechte Spalte, Absatz 2; Abbildung 7 * | 1-3,5 | G 01 R 1/067 G 01 R 31/28 |
| Y | --- | 4,6-8 | |
| Y | WESTERN ELECTRIC TECHNICAL DIGEST, Nr. 38, April 1975, Seite 11, Western Electric; B.G. CASNER et al.: "Method of making a test probe" * Seite 11, Absatz 1 * --- | 4 | |
| Y | IBM TECHNICAL DISCLOSURE BULLETIN, Band 15, Nr. 9, Februar 1973, Seiten 2681-2682; R. BOVE et al.: "Impedance terminator for AC testing monolithic chips" * Seite 2681, Absatz 2 * --- | 6 | |
| Y | M. HARTLEY JONES: "A practical introduction to electronic circuits", 1977, Seiten 40-43, Cambridge University Press, Cambridge, GB * Seite 42, rechte Spalte, letzter Absatz - Seite 43, linke Spalte, Absatz 3; Seite 44, Absatz 2 * --- | 7 | |
| Y | US-A-3 995 175 (HOYT & ZAUCHNER) * Spalte 1, Zeilen 51-53; Abbildung 1 * ----- | 8 | |

**RECHERCHIERTE SACHGEBIETE (Int. Cl.4)**

G 01 R

Der vorliegende Recherchenbericht wurde für alle Patentansprüche erstellt

| Recherchenort | Abschlußdatum der Recherche | Prüfer |
|---|---|---|
| DEN HAAG | 03-12-1987 | HARRISON R.J. |